# EUROPÄISCHE PATENTSCHRIFT

(11) **EP 4 507 953 B1**
(45) Veröffentlichungstag und Bekanntmachung des Hinweises auf die Patenterteilung: **15.04.2026**
(21) Anmeldenummer: 23730497.7
(22) Anmeldetag: 02.06.2023
(51) Int. Cl.: B61L 27/60, G01M 17/08

(54) **VERFAHREN UND SYSTEM ZUR ERMITTLUNG DES ENERGIEVERBRAUCHS EINES SCHIENENFAHRZEUGS**
METHOD AND SYSTEM FOR DETERMINING THE ENERGY CONSUMPTION OF A RAIL VEHICLE
PROCÉDÉ ET SYSTÈME DE DÉTERMINATION DE LA CONSOMMATION D'ÉNERGIE D'UN VÉHICULE FERROVIAIRE

(30) Priorität: 21.06.2022 DE 102022206182
(43) Veröffentlichungstag der Anmeldung: 19.02.2025
(73) Patentinhaber: Siemens Mobility GmbH, 80997 München (DE)
(72) Erfinder: DORSCH, Alexander, 90473 Nürnberg (DE); JUNG, Martin, 91052 Erlangen (DE); VANGERMAIN, Bernd, 91058 Erlangen (DE); WEIS, Tobias, 91353 Hausen (DE)
(74) Vertreter: Siemens Patent Attorneys
(86) Internationale Anmeldenummer: PCT/EP2023/064831
(87) Internationale Veröffentlichungsnummer: WO 2023/247158

(56) Entgegenhaltungen:
- EP-A1- 3 312 073
- EP-A1- 3 760 511
- CN-A- 101 825 520
- CN-A- 110 553 864
- BRAUER H-M ET AL: "HELLASSPRINTER - ERSTE ELEKTRISCHE LOKOMOTIVE FUER GRIECHENLAND", EB- ELEKTRISCHE BAHNEN, DIV-DEUTSCHER INDUSTRIEVERLAG, DE, vol. 96, no. 4, 1 April 1998 (1998-04-01), pages 107 - 114, XP000750878, ISSN: 0013-5437
- RICK F ET AL: "ZUG- UND BREMSKRAFTERMITTLUNG MITTELS ONLINE-FAHRWIDERSTANDSMESSUNG//TRACTIVE AND BRAKING EFFORT DETERMINATION BY ONLINE RUNNING RESISTANCE MEASURING//DETERMINATION D'EFFORTS DE TRACTION OU DE FREINAGE PAR MESURE DE LA RESISTANCE A L'AVANCEMENT ONLINE", EB- ELEKTRISCHE BAHNEN, DIV-DEUTSCHER INDUSTRIEVERLAG, DE, vol. 101, no. 3, 1 March 2003 (2003-03-01), pages 120 - 124, XP001145215, ISSN: 0013-5437

## Beschreibung

Die Erfindung betrifft ein Verfahren und ein System zur Ermittlung des Energieverbrauchs eines Schienenfahrzeugs, wie z.B. einer Lok oder einem Wagen, bei einer Testfahrt. Die Erfindung sieht dabei insbesondere vor, dass beliebige Kombinationen von Zugkonfiguration, Strecken und Fahrplänen mit einem Testaufbau realitätsnah nachgestellt werden können.

Aufgrund erhöhter Sensitivität gegenüber dem Energieverbrauch wird zunehmend ein höherer Wert auf dessen Minimierung bzw. dessen genaue Einschätzung gelegt. Dabei kann es vorkommen, dass bereits in der Angebotsphase für bestimmte Strecken mit vorgegebenen Fahrplänen sowohl für Personenverkehr als auch für den Güterverkehr ein zu erwartender Energieverbrauch vorab berechnet und von Anbietern von Fahrzeugen zugesichert wird. Dabei ist oft bei Auftragserteilung während des Projektverlaufs auch ein Nachweis eines errechneten Wertes für den Energieverbrauch eines Fahrzeugs auf der realen Strecke erforderlich, wozu eine vorgesehene Zugkonfiguration auf der realen Strecke unter realen Bedingungen, z.B. Beladung der Wagen um Fahrgäste oder Frachtgut zu simulieren, den Fahrplan abfahren. Während der Fahrt wird der Energiebedarf gemessen und mit dem berechneten Wert verglichen. Abweichungen zwischen zugesagten und gemessenen Wert, die einen Mehrverbrauch des Fahrzeuges bedeuten würden, werden mit z.T. hohen Vertragsstrafen pönalisiert.

Ein Nachteil der dazu verwendeten Verfahren ist, dass mehrere Vorgänge und Arbeitsschritte hierbei sehr zeit- und kostenintensiv sind und zudem Unsicherheit in die Berechnung und Messung bringen und damit ein höheres Risiko in das Projekt.
(a) Die reale Strecke muss für mehrere Testfahrten gebucht und freigehalten werden, wobei hier immer der Fall auftreten kann, dass die Fahrt aufgrund von betrieblichen Störungen etc. unterbrochen oder schlimmstenfalls abgebrochen werden muss. Ein streckenkundiger Triebfahrzeugführer (oftmals mit "Tf" abgekürzt) muss ebenfalls verfügbar sein.
(b) Die reale Zugkonfiguration zur Verfügung zu stellen ist oftmals kompliziert, da die Fahrzeuge dazu entweder aus dem aktiven Betrieb genommen werden müssen oder die Fahrzeuge anderweitig schwer verfügbar sind, da die Nachweise oft in früheren Phasen des Projekts zu erbringen sind und die Fahrzeuge unter Umständen noch nicht gefertigt sind oder aus Kundenbeständen nicht abgerufen werden können.
(c) Nachweise mit Personenwagen müssen meist mit vorgegebener Sitzplatzbelegung durchgeführt werden. Der Beladevorgang kann je nach Wagenanzahl und zu simulierender Belegung äußerst hohe Aufwände verursachen. Für Nachweise bei Frachtzügen muss auch eine repräsentative Beladung hinreichend gut vorgesehen werden.
(d) Die Fahrweise des Triebfahrzeugführers, also z.B. wie stark und wie lange beschleunigt und abgebremst wird, hat einen außerordentlich hohen Einfluss auf den Energieverbrauch. Für den Tf ist es sehr schwer die in der Berechnung angesetzten Zugkraftverläufe in der Realität exakt nachzufahren. Genauso schwer ist es, das genaue Fahrverhalten eines Tf in der Berechnung zu berücksichtigen. Die Abweichung von Berechnung und Umsetzung in der Messfahrt kann daher mitunter sehr groß sein.
(e) Die Randbedingungen der Berechnung, wie Netzspannung, Gegenwind oder Außentemperatur, werden in der Ausschreibung häufig exakt vorgegeben. Diese Bedingungen sind oftmals von der Umwelt oder der Infrastruktur abhängig und auf realer Strecke kaum zu steuern. Die größten Einflussfaktoren auf die Testfahrt und dessen Ergebnis während des normalen Betriebs sind:
   - Tunnelfahrt und Gegenverkehr, da diese Einfluss auf den Fahrwiderstand haben,
   - Betriebliche Störungen, da diese den angestrebten Fahrplan oder die gesamte Messung behindern können,
   - Schwankende Netzspannung, z.B. aufgrund von Gegenverkehr, da diese die Effizienz des Fahrzeugs beeinflusst,
   - Wettereinflüsse wie z.B. Wind, der den Fahrwiderstand erhöht und damit ebenfalls den Energiebedarf, wobei Wind zudem auf der Strecke nicht praktikabel messbar ist, und Regen und andere Wettereinflüsse, welche während der limitierten Testzeit auftreten können.

In der Vergangenheit war es gängige Praxis, die Energieeffizienz einer Lokomotive anhand eines Gesamtwirkungsgrades in einem bestimmten Arbeitspunkt zu bestimmen. Ein Arbeitspunkt wird dabei durch eine Geschwindigkeit und eine Zugkraft (vorzugsweise am Rad) definiert. Im Angebotsverlauf wurden, zumeist für mehrere vorgegebene Arbeitspunkte, rechnerisch unter bestimmten Randbedingungen die jeweiligen Wirkungsgrade ermittelt und vertraglich zugesagt. Bei Durchführung des Projekts musste jeder Wirkungsgrad einzeln per Messung auf der Schiene nachgewiesen werden. Dazu wurden die Lokomotiven über einen bestimmten Zeitraum konstant im zu messenden Arbeitspunkt gehalten und die Leistungsabgabe am Rad P(Rad) = F * v (mit der Kraft F und der Geschwindigkeit v) mit der über die Oberleitung aufgenommenen Leistung P(Netz) = I(Netz) · U(Netz) (mit der Stromstärke I(Netz) und der Netzspannung U(Netz) ins Verhältnis gesetzt. Die allgemeine Definition des Wirkungsgrades η ist in diesem Falle: η = P(Rad) / P(Netz).

Der Wirkungsgrad ist dabei im Normalfall für mehrere Arbeitspunkte anzugeben. Basierend auf diesen Wirkungsgraden ist es möglich zu berechnen, wie hoch der Energieverbrauch für bestimmte Einsätze sein wird, z.B. im Güterverkehr oder Personenverkehr.

Diese Messungen werden derzeit auf einer realen Strecke mit Zügen durchgeführt, die eine Testbeladung oder eine simulierte Beladung aufweisen. Dies ist aufwändig, zeitintensiv, Fehlern unterworfen und mit vergleichsweise hohe Kosten gekuppelt.

In der letzten Zeit wird der oben beschriebene rechnerische und messtechnische Nachweis häufig vertraglich eingefordert. Daraus ergibt sich für einen Fahrzeuganbieter zwangsläufig die Notwendigkeit, deutlich genauere Energieverbrauchswerte in der Angebotsphase zu bestimmen und vertraglich zuzusichern.

Aus Dokument "HellasSprinter - erste elektrische Lokomotive für Griechenland", Brauer et. al., EB-Elektrische Bahnen, DIV-Deutscher Industrieverlag, DE, Bd.96, Nr.4, 01.04.1998, Seiten 107-114, XP000750878, ISSN: 0013-5437, ist eine Ermittlung eines Energieverbrauchs bekannt, bei der eine Wirkungsgradkette des Fahrzeugs im Rahmen einer Simulation ermittelt wurde.

Aus Dokument "Zug- und Bremskraftermittlung mittels Online-Fahrwiderstandsmessung", Rick Fetal, EB-Elektrische Bahnen, DIV-Deutscher Industrieverlag, DE, Bd.101, Nr.3, 01.03.2003, Seiten 120-124, XP001145215, ISSN: 0013-5437, ist eine Methode zur Bestimmung der Zugkraft von Triebfahrzeugen bekannt, die auf der Online-Erfassung aller Fahrwiderstandskomponenten basiert.

Aus Dokument CN 101825520 A ist ein Gesamtprüfstand für Schienenfahrzeugtriebwerke bekannt, der zum Bereich der Prüfung und Steuerung von elektrischen Triebfahrzeugsystemen gehört.

Aus Dokument EP 3 760 511 A1 ist ein Verfahren zum Betreiben eines Fahrzeugs bekannt, bei dem eine Fahrdatenermittlungseinheit Fahrkurvendaten bestimmt und eine Antriebseinheit auf Grundlage der Fahrkurvendaten gesteuert wird.

Aus Dokument EP 3 312 073 A1 ist ein Verfahren zur Prüfung eines Eisenbahnsystems bekannt. Während eines Betriebs des Eisenbahnsystems werden implementierte Betriebsprozesse identifiziert und Prozessergebnisse der identifizierten Betriebsprozesse aus dem Eisenbahnsystem erfasst und in einem Testrechner mit Referenzdaten verglichen, um den Ablauf der identifizierten Betriebsprozesse zu prüfen.

Aus Dokument CN 110 553 864 A ist ein Überwachungssystem für den Simulationsbetrieb von Straßenbahnen bekannt.

Es ist eine Aufgabe der vorliegenden Erfindung, ein alternatives, komfortableres Verfahren und ein entsprechendes System zur Ermittlung des Energieverbrauchs eines Schienenfahrzeugs, z.B. einer Lok oder einem Wagen, bei einer Testfahrt anzugeben, mit dem die oben beschriebenen Nachteile vermieden werden und insbesondere beliebige Kombinationen von Zugkonfiguration, Strecken und Fahrplänen mit einem Testaufbau realitätsnah nachgestellt werden können.

Diese Aufgabe wird durch ein Verfahren gemäß Patentanspruch 1 und einem System gemäß Patentanspruch 13 gelöst.

Das erfindungsgemäße Verfahren zur Ermittlung eines Energieverbrauchs eines Schienenfahrzeugs, bevorzugt einer

Lok oder einem Wagen, bei einer Testfahrt umfasst die folgenden Schritte:
a) Bereitstellen eines Loksystems umfassend eine Bremslok-Komponente und eine Prüflok-Komponente (die auch als "Fahrkomponente" bezeichnet werden könnte), welche miteinander gekuppelt sind, wobei die Bremslok-Komponente während der Testfahrt von der Prüflok-Komponente bewegt wird, und wobei ein Steuersystem die Prüflok-Komponente und die Bremslok-Komponente während der Testfahrt steuert,
b) Bereitstellen einer Teststrecke, auf der das Loksystem während der Testfahrt fährt,
c) Bereitstellen von Basisdaten zur Testfahrt umfassend zumindest Informationen zur Zugkomposition, Beladung, Streckenprofil und zum Fahrplan,
d) Ermitteln von Fahrdaten aus den Basisdaten, welche zumindest Informationen zur Zugkraft und zu Geschwindigkeitsprofilen der Testfahrt umfassen, und dazu ausgelegt sind, die Prüflok-Komponente während der Testfahrt auf der Teststrecke zu steuern, und Übermitteln der Fahrdaten an das Steuersystem,
e) Ermitteln von Bremsdaten aus den Basisdaten, welche zumindest Informationen zur Hemmung bei der Testfahrt durch die Zugkomposition, Beladung und/oder das Streckenprofil umfassen, und dazu ausgelegt sind, die Bremslok-Komponente während der Testfahrt auf der Teststrecke gemäß der Hemmung zu bremsen, und Übermitteln der Bremsdaten an das Steuersystem,
f) Durchführung der Testfahrt auf der Teststrecke und Messung des Energieverbrauchs der Prüflok-Komponente während diese gemäß den Fahrdaten gesteuert wird und gleichzeitig durch die Bremslok-Komponente gemäß den Bremsdaten gebremst wird.

Die Ermittlung eines Energieverbrauchs wird also während einer Testfahrt auf einer Teststrecke durchgeführt. Auch wenn als Teststrecke theoretisch eine (abgesperrte) reale Strecke verwendet werden kann, ist bevorzugt, dass die Testfahrt auf einer extra als Teststrecke konzeptionierten Strecke durchgeführt wird, z.B. auf einem geraden Schienenstrang oder einem Kreis. Dadurch können ideale Laborbedingungen geschaffen und Umwelteinflüsse sehr genau berücksichtigt oder unterdrückt werden.

Das Schienenfahrzeug, für das der Energieverbrauch gemessen werden soll, kann ein angetriebenes Schienenfahrzeug sein, z.B. eine Lokomotive, ein Triebzug oder ein Triebwagen dessen Energieverbrauch gemessen wird. Es kann aber auch ein nichtangetriebenes Schienenfahrzeug sein, z.B. ein Wagen. In diesem Falle ist der gemessene Energieverbrauch derjenige der für die Bewegung des nicht-angetriebenen Schienenfahrzeugs aufgewendet werden muss.

Das Loksystem mit Bremslok-Komponente und Prüflok-Komponente umfasst bevorzugt keine weiteren Loks oder Wagen, wobei jedoch durchaus andererseits auch zu vermessene Wagen angekuppelt sein könnten. Die Bremslok-Komponente simuliert dabei während der Testfahrt bevorzugt die Wagen (bzw. weitere Wagen), deren Beladung sowie bevorzugt auch eine Strecke, z.B. die reale Strecke, auf der das Schienenfahrzeug später eingesetzt werden soll. Es ist auch bevorzugt, zu vermessende Wagen zu simulieren (ggf. ohne dass eine Strecke simuliert wird). Die Bremslok-Komponente wird dann auf der Testfahrt von der Prüflok-Komponente gezogen oder geschoben.

Auch wenn als Prüflok-Komponente bevorzugt eine Lokomotive als "Prüflok" eingesetzt wird und als Bremslok-Komponente eine weitere Lokomotive als "Bremslok", können diese Komponenten auch in einer einzigen Lokomotive realisiert sein, z.B. in dem ein angetriebenes Drehgestell in der Lokomotive als Prüflok-Komponente verwendet wird und ein anderes als Bremslok-Komponente. In einem Triebzug könnte eine Triebeinheit (insbesondere die vordere) als Prüflok-Komponente verwendet werden und eine andere Triebeinheit (insbesondere die hintere) als Bremslok-Komponente. Im Falle eines Triebzuges kann es auch vorteilhaft sein, wenn sich Wagen zwischen Prüflok-Komponente und Bremslok-Komponente befinden, da dann ein kompletter Triebzug ohne Modifikationen für die Testfahrt verwendet werden kann.

Geeignete Steuereinheiten zur Steuerung der Prüflok-Komponente und der Bremslok-Komponente während der Testfahrt sind bekannt. z.B. können Steuereinheiten zur automatischen Steuerung einer Lok bzw. von Triebeinheiten verwendet werden, wie sie derzeit bereits eingesetzt werden. Das Steuersystem kann sich dann aus Steuereinheiten der Prüflok-Komponente oder der Bremslok-Komponente ergeben. Es kann aber auch ein Steuersystem verwendet werden, welches die Komponenten gemeinschaftlich steuert, z.B. durch direkten Einwirkung auf die Steuereinheiten der beiden Komponenten (z.B. von Loks), z.B. per Funk oder bei einem Onboard-System mittels einer Kabelverbindung.

Die Teststrecke sollte möglichst einfach gestaltet und eben sein, Es bieten sich insbesondere Kreisbahnen an, die ggf. auch aus zwei Kreishälften gebildet sein können, die mittels geraden Teilstücken miteinander zu einem Ring verbunden sind. Je einfacher die Form der Teststrecke gestaltet ist, und je größer der Kurvenradius ist, desto genauer sind die Ergebnisse des Verfahrens. Es kann wie gesagt theoretisch auch eine reale Strecke als Teststrecke verwendet werden, z.B. zum Testen einer Wagenkonfiguration.

Die Basisdaten zur Testfahrt bilden die Grundlage der Simulation einer realen Zugfahrt. Sie müssen zumindest Informationen zur Zugkomposition umfassen, also wieviel Wagen simuliert werden sollen, welcher Art die Wagen sind und insbesondere auch, welchen Fahrwiderstand (z.B. Rollwiderstand und/oder Windwiderstand) sie haben. Im Grunde sind hier Daten bevorzugt, die Aufschluss darüber geben, wieviel Leistung erforderlich ist, um die Anzahl der Wagen bei bestimmten Geschwindigkeiten und Streckenprofilen (Steigungen, Ebenen, Gefällen) zu ziehen. Ein Beispiel für eine Information zur Zugkomposition könnte eine Liste der gewünschten Wagen sein und eine zweidimensionale Funktion P(v, S) oder entsprechende Werteliste für jeden Wagen, die angibt, welche Leistung (oder welche Zugkraft) P erforderlich ist, wenn der Wagen mit der Geschwindigkeit v auf einer Strecke mit der Steigung S gezogen wird, wobei ein negatives S einem Gefälle entsprechen würde. Die Information zur Zugkomposition könnte aber auch eine zusammengefasste Funktion (oder besagte Werteliste) P(v, S) umfassen die die Leistung für eine Geschwindigkeit v und eine Steigung S für einen ganzen Wagenzug angibt.

Des Weiteren umfassen die Basisdaten zur Testfahrt Informationen zur Beladung. Diese können getrennt von den Informationen zur Zugkomposition vorliegen oder aber auch vereint mit diesen. Eine Trennung der beiden Informationen hat den Vorteil, dass im Rahmen mehrerer Testfahrten die Beladung unabhängig zur Zugkonfiguration geändert werden könnte.

Wichtig ist, dass die Basisdaten Informationen zum Streckenprofil umfassen, also wo genau Steigungen, Ebenen oder Gefälle vorhanden sind und wie groß die Kurvenradien sind, und zum Fahrplan, also mit welcher Geschwindigkeit der Zug wann auf der Strecke fährt, wann er bremst und wann er beschleunigt.

Die Fahrdaten sind wichtig zum Betreiben der Prüflok-Komponente. Sie sollten im Grunde einer realen Fahrt der Prüflok-Komponente auf der simulierten Strecke entsprechen und sind dazu ausgelegt, die Prüflok-Komponente während der Testfahrt auf der Teststrecke zu steuern. Im Grunde ist das Generieren von Fahrdaten im Stand der Technik bekannt, und umfassen typischerweise Informationen zur Zugkraft und zu Geschwindigkeitsprofilen (also Beschleunigungen, Bremsungen und Halte). Die Fahrdaten werden aus den Basisdaten abgeleitet, insbesondere aus den Informationen zum Fahrplan und ggf. auch aus dem Streckenprofil.

Die Fahrdaten werden dann an das Steuersystem (für die Prüflok-Komponente) übermittelt, insbesondere an eine Steuereinheit der Prüflok-Komponente.

Die Bremsdaten sind wichtig zum Betreiben der Bremslok-Komponente und dienen der Simulation einer realen oder zumindest gewünschten Strecke und ggf. weiterer Hemmnisse wie Wagen. Sie umfassen zumindest Informationen zur Hemmung bei der Testfahrt durch die Zugkomposition, Beladung und/oder das Streckenprofil und sind dazu ausgelegt, die Bremslok-Komponente während der Testfahrt auf der Teststrecke gemäß dieser Hemmung zu bremsen. Dabei sollten die Bremsdaten in dem Fall, in dem eine Testfahrt auf einer realen oder gewünschten Strecke simuliert werden soll, die Hemmnisse dieser Strecke umfassen. In dem Falle, in dem lediglich die Auswirkungen einer Wagenkonfiguration auf den Energieverbrauch gemessen werden soll (insbesondere bei einer Testfahrt auf einer realen Strecke), ist es nicht unbedingt notwendig, dass die Bremsdaten Daten zum Hemmnis einer Strecke umfassen. Bei dem oben beschriebenen Beispiel, bei dem die Zugkomposition (hier der Einfachheit halber bevorzugt zusammen mit der Beladung) mit einer zweidimensionalen Funktion zur Leistung P(v, S) angegeben ist, kann einfach die Steigung S aus dem Streckenprofil und die Geschwindigkeit v aus dem Fahrplan eingesetzt werden. Dies sollte natürlich so geschehen, dass auf jeder Position der simulierten Strecke der Fahrplan mit dem Streckenprofil synchronisiert ist. Die daraus für die gesamte Strecke generierte Leistungskurve kann dann in Bremsdaten konvertiert werden. Im Grunde sind die Bremsdaten ähnlich zu der Leistungskurve. Je größer die aufzubringende Leistung, desto größer muss die Bremsung sein und umgekehrt. Selbstverständlich ist dies nur ein Beispiel, Es können in den Basisdaten auch gleich (z.B. statt den Leistungsdaten) eine mathematische Funktion zur Bremsung B(v, S) vorhanden sein, und direkt eine Bremskurve mittels dem Fahrplan und dem Streckenprofil berechnet werden. Es sei darauf hingewiesen, dass die Bremsdaten auch negativ sein könnten, d.h. eine Beschleunigung bewirken, wie sie z.B. auf einer Gefällstrecke auftritt.

Die Bremsdaten werden dann an das Steuersystem (für die Bremslok-Komponente) übermittelt, insbesondere an eine Steuereinheit der Bremslok-Komponente.

Liegen die Fahrdaten und die Bremsdaten vor, dann kann eine Testfahrt auf der Teststrecke mit dem Loksystem durchgeführt werden. Die Prüflok-Komponente wird währenddessen gemäß den Fahrdaten gesteuert und gleichzeitig durch die Bremslok-Komponente gemäß den Bremsdaten gebremst. Während der Testfahrt erfolgt dann die Messung des Energieverbrauchs. Durch die besondere Steuerung der Bremslok-Komponente wird während der Messung eine Fahrt auf einer Strecke (welche sich von der Teststrecke unterscheidet und einer realen Strecken entsprechen kann) mit einem gewünschten Zug aus der Prüflok-Komponente und einer Anzahl von Wagen simuliert.

Die Messung kann dann direkt für den Energieverbrauch eines Schienenfahrzeugs in Form einer zu testenden Lok verwendet werden oder sie dient der Vermessung eines Wagens als Schienenfahrzeug.

Auf diese Weise können mittels des erfindungsgemäßen Verfahrens beliebige Kombinationen von Zugkonfiguration, Strecke bzw. Topografie und Fahrplan mit zwei Lokomotiven auf einer an sich beliebigen Teststrecke simuliert werden. Es sei angemerkt, dass auch Eigenschaften der Teststrecke in die Basisdaten aufgenommen und in die Bremsdaten eingehen können. Damit können (positive oder negative) Steigungen oder Kurvenradien der Teststrecke kompensiert werden und der Einfluss der Teststrecke auf die Messung eliminiert werden.

Mit anderen Worten wird das nachzufahrende Fahrspiel mittels einer Zugkomposition, Strecke und Fahrplan, rechnerisch so aufbereitet, dass ein Bremskraftprofil (die Bremsdaten) und ein Zugkraftprofil (die Fahrdaten) entsteht. Das Zugkraftprofil wird z.B. auf die zu vermessende Lok ("Prüflok-Komponente") aufgespielt, das andere auf die gekuppelte Bremslok-Komponente (z.B. einer Bremslok), wobei die beiden Komponenten bzw. Loks ggf. auch mittels eines gemeinsamen Steuersystems gesteuert werden können. Das Bremskraftprofil der Bremslok-Komponente ist dabei so gewählt, dass das abzufahrende Profil die Fahrwiderstände der Strecke und der Zugkomposition abbildet. Die zu vermessende Lok fährt das Fahrprofil so ab wie es ein Lokführer unter betrieblichen Bedingungen tun würde. Es wird also bevorzugt das reale Fahrspiel so aufbereitet und in Form von Fahrprofilen auf zwei gekuppelte Lokomotiven aufgespielt, dass die realen Bedingungen (Zugkonfiguration, Strecke und deren Topografie, Fahrplan) auf der, vorzugsweise ringförmigen, Teststrecke, simuliert werden können.

Das Anmieten und Freihalten von realen Strecken im normalen Betrieb kann durch die Erfindung entfallen, da die Testfahrten im Grunde auf jeder beliebigen (auch firmeneigener) Teststrecke (Testring) durchgeführt werden können. Hierdurch erhält das Projekt maximale Flexibilität was Ort, Zeitpunkt und Dauer der Nachweisfahrten betrifft.

Durch das erfindungsgemäße Verfahren kann im Grunde jede beliebige Zugkonfiguration nachgestellt und zur Messung herangezogen werden. Das ist unabhängig davon, ob die realen Fahrzeuge (damit sind hier insbesondere Wagen gemeint) verfügbar sind oder z.B. in der Angebotsphase noch nicht produziert wurden und nur als digitales Modell verfügbar sind. Zudem ist die Beladung der Fahrzeuge nun nur noch ein Parameter in der Fahrspielberechnung repräsentiert und kann ohne Aufwand angepasst werden. Der Aufwand für ein Beladen der Fahrzeugkonfiguration per Hand entfällt.

Durch die Fahrprofile (Fahrdaten und Bremsdaten), welche auf beide Lokomotiven aufgespielt werden, erhält man ein reproduzierbares Fahrverhalten der Prüflok-Komponente. Die Abweichung von Berechnung zu Messung wird hierdurch auf ein Minimum reduziert, wodurch sich auch die Projektrisiken deutlich reduzieren.

Die Durchführung auf einer geschlossenen Teststrecke (Testring) bietet viele Vorteile im Vergleich zur realen Strecke. So kann z.B. die Netzspannung individuell gesteuert werden, es gibt keinen ungeplanten Gegenverkehr, Tunnelfahrten, und betriebliche Störungen sind ebenfalls sehr unwahrscheinlich. Auf Wettereinflüsse kann ebenfalls entsprechend reagiert werden, indem die Messung, bei massiver Abweichung zu den abgestimmten Randbedingungen, flexibel durchgeführt werden kann. Einflüsse wie z.B. durch Gegenwind, fallen auf einer ringförmigen Teststrecke im Testgelände, welche meist als Kreis ausgeführt sind, weniger stark ins Gewicht und können bei Bedarf durch die vor Ort installierten Messstationen zudem genauer aufgezeichnet werden als auf einer realen Strecke.

Das erfindungsgemäße System zur Ermittlung eines Energieverbrauchs eines Schienenfahrzeugs, insbesondere einer Lokomotive, einem Triebwagen, einem Triebzug oder einem Wagen, bei einer Testfahrt ist dazu geeignet und insbesondere ausgelegt, das erfindungsgemäße Verfahren anzuwenden. Das System umfasst die folgenden Komponenten:
- in dem Fall, in dem als Schienenfahrzeug ein nicht-angetriebenes Schienenfahrzeug (z.B. ein Wagen) vermessen werden soll, ein Loksystem umfassend eine Prüflok-Komponente, insbesondere eine Prüflok, und eine Bremslok-Komponente, insbesondere eine Bremslok, und in dem Fall, in dem als Schienenfahrzeug ein angetriebenes Schienenfahrzeug vermessen werden soll, eine Bremslok als Bremslok-Komponente mit einer Kupplung, mit der sie für eine Testfahrt mit dem angetriebenen Schienenfahrzeug als Prüflok-Komponente zu einem Loksystem gekuppelt werden kann,
- ein Steuersystem dazu ausgelegt, Bremslok-Komponente und Prüflok-Komponente zu steuern, und bevorzugt umfassend zumindest eine Steuereinheit für die Bremslok-Komponente, und eine Schnittstelle zur Datenübertragung an die Prüflok-Komponente,
- eine Teststrecke, auf der das Loksystem während der Testfahrt fährt,
- eine Datenschnittstelle ausgelegt zum Empfang von Basisdaten zur Testfahrt umfassend zumindest Informationen zur Zugkomposition, Beladung, Streckenprofil und zum Fahrplan,
- eine Ermittlungseinheit ausgelegt zum
   i) Ermitteln von Fahrdaten aus den Basisdaten, welche zumindest Informationen zur Zugkraft und zu Geschwindigkeitsprofilen der Testfahrt umfassen, und dazu ausgelegt sind, die Prüflok-Komponente während der Testfahrt auf der Teststrecke zu steuern,
   ii) Ermitteln von Bremsdaten aus den Basisdaten, welche zumindest Informationen zur Hemmung bei der Testfahrt durch die Zugkomposition, Beladung und/oder das Streckenprofil umfassen, und dazu ausgelegt sind, die Bremslok-Komponente während der Testfahrt auf der Teststrecke gemäß der Hemmung zu bremsen,
   iii) Übermitteln der Fahrdaten und Bremsdaten an das Steuersystem, wobei die Bremsdaten zum Bremsen der Bremslok-Komponente vorgesehen sind und die Fahrdaten zum Steuern der Prüflok-Komponente,
- eine Messeinheit ausgelegt zur Messung des Energieverbrauchs der Prüflok-Komponente während diese auf einer Testfahrt mit dem Loksystem auf der Teststrecke gemäß den Fahrdaten gesteuert wird und gleichzeitig durch die Bremslok-Komponente gemäß den Bremsdaten gebremst wird.

Das System muss nicht unbedingt die Prüflok-Komponente umfassen, da diese ja im Grunde austauschbar sein kann. Es ist vielmehr zur Prüfung beliebiger Schienenfahrzeuge, z.B. Prüfloks, ausgelegt, wobei eine aktuell zu prüfende Prüflok einfach für eine Testfahrt auf der Teststrecke mit der Bremslok (als Bremslok-Komponente) des Systems gekuppelt werden muss. Dazu weist die Bremslok-Komponente eine Kupplung auf, insbesondere eine Universalkupplung, mit der sie für eine Testfahrt mit der Prüflok-Komponente zu einem Loksystem gekuppelt werden kann.

In dem Fall, in dem ein Wagen vermessen werden soll, muss das System jedoch eine Prüflok-Komponente umfassen, da ja der Wagen gezogen werden muss. Es ist diesbezüglich bevorzugt, zuerst die Prüflok-Komponente zu vermessen und dann den Wagen, damit der Einfluss der Prüflok-Komponente auf das Ergebnis eliminiert werden kann.

Das Steuersystem ist zur Steuerung des Loksystems ausgelegt. Dies kann insbesondere dadurch erreicht werden, dass das Steuersystem in der Lage ist, sowohl die Prüflok-Komponente als auch die Bremslok-Komponente zu steuern, z.B. als übergeordnetes Steuersystem oder mittels Übermittlung der Fahrdaten an eine Steuereinheit der Prüflok-Komponente. In der Praxis kann es ein Steuersystem sein, welches zumindest eine Steuereinheit für die Bremslok-Komponente aufweist und eine Schnittstelle zur Datenübertragung an die Prüflok-Komponente.

Die Teststrecke wurde vorangehend bereits beschrieben.

Die Datenschnittstelle kann z.B. zur Datenkommunikation per Funk ausgestaltet sein und damit z.B. Basisdaten von einer Leitstelle für die Testfahrt zu empfangen. Diese Basisdaten wurden vorangehend bereits beschrieben.

Die Ermittlungseinheit ermittelt Fahrdaten für die Prüflok-Komponente und Bremsdaten für die Bremslok-Komponente und sendet diese an die entsprechende Lok. Wie genau diese Fahrdaten und Bremsdaten ermittelt werden, wurde weiter oben bereits beschrieben. Das Übermitteln der Fahrdaten und Bremsdaten an das Steuersystem kann auf unterschiedliche Art und Weise erfolgen, je nachdem wie das Steuersystem aufgebaut ist. Das Steuersystem kann ein übergeordnetes System sein, welches in der Lage ist, eigenständig eine Prüflok-Komponente (bzw. eine Prüflok) zu steuern. Es kann aber auch einfach die Fahrdaten an die Prüflok-Komponente senden, welche dann von ihrer eigenen Steuereinheit gemäß der Fahrdaten gesteuert wird. Auch dieses übersenden von Fahrdaten wird als eine Art Steuerung im Sinne der Erfindung angesehen, da die Prüflok-Komponente sich gemäß dieser Fahrdaten bei der Testfahrt bewegt. In dem Fall, in dem das Steuersystem ein übergeordnetes System ist, werden Fahrdaten an das Steuersystem gesendet, und das Steuersystem steuert die Prüflok-Komponente (z.B. eine Prüflok) entsprechend. In dem Falle, dass die Prüflok-Komponente indirekt vom Steuersystem gesteuert wird, erhält die Prüflok-Komponente (z.B. eine Prüflok) die Fahrdaten mittels einer bevorzugten Datenschnittstelle auf ihre eigene Steuereinheit. Die Bremslok-Komponente (z.B. eine Bremslok) erhält die Bremsdaten bevorzugt auf ihrer eigenen Steuereinheit (welche bevorzugt Teil des Steuersystems ist) und bremst gemäß dieser Bremsdaten.

Die Messeinheit arbeitet wie vorangehend beschrieben und misst den Energieverbrauch der Prüflok-Komponente während der Testfahrt.

Die Erfindung kann insbesondere in Form einer Rechnereinheit, insbesondere in einer Steuereinrichtung, mit geeigneter Software realisiert sein. Die Rechnereinheit kann z.B. hierzu einen oder mehrere zusammenarbeitende Mikroprozessoren oder dergleichen aufweisen. Insbesondere kann sie in Form von geeigneten Softwareprogrammteilen in der Rechnereinheit realisiert sein. Eine weitgehend softwaremäßige Realisierung hat den Vorteil, dass auch schon bisher verwendete Rechnereinheiten in Triebzügen oder Zugverbänden bzw. in deren Wagen auf einfache Weise durch ein Software- bzw. Firmware-Update nachgerüstet werden können, um auf die erfindungsgemäße Weise zu arbeiten. Insofern wird die Aufgabe auch durch ein entsprechendes Computerprogrammprodukt mit einem Computerprogramm gelöst, welches direkt in eine Speichereinrichtung einer Rechnereinheit ladbar ist, mit Programmabschnitten, um alle Schritte des erfindungsgemäßen Verfahrens auszuführen, wenn das Programm in der Rechnereinheit ausgeführt wird. Ein solches Computerprogrammprodukt kann neben dem Computerprogramm gegebenenfalls zusätzliche Bestandteile wie z.B. eine Dokumentation und/oder zusätzliche Komponenten, auch Hardware-Komponenten, wie z. B. Hardware-Schlüssel (Dongles etc.) zur Nutzung der Software, umfassen. Zum Transport zur Rechnereinheit und/oder zur Speicherung an oder in der Rechnereinheit kann ein computerlesbares Medium, beispielsweise ein Memorystick, eine Festplatte oder ein sonstiger transportabler oder fest eingebauter Datenträger dienen, auf welchem die von einer Rechnereinheit einlesbaren und ausführbaren Programmabschnitte des Computerprogramms gespeichert sind.

Weitere, besonders vorteilhafte Ausgestaltungen und Weiterbildungen der Erfindung ergeben sich aus den abhängigen Ansprüchen sowie der nachfolgenden Beschreibung, wobei die Ansprüche einer Anspruchskategorie auch analog zu den Ansprüchen und Beschreibungsteilen zu einer anderen Anspruchskategorie weitergebildet sein können und insbesondere auch einzelne Merkmale verschiedener Ausführungsbeispiele bzw. Varianten zu neuen Ausführungsbeispielen bzw. Varianten kombiniert werden können.

Gemäß einem bevorzugten Verfahren werden besondere Basisdaten verwendet. Diese Basisdaten umfassen Fahrwiderstände derjenigen Fahrzeuge (insbesondere Wagen), die in der Zugkomposition eingesetzt werden, bzw. simuliert werden sollen. Diese Fahrwiderstände umfassen zumindest eine Größe der Gruppe Traktion, Gewicht und Luftwiderstand der eingesetzten Fahrzeuge. Alternativ oder zusätzlich geben die Basisdaten bevorzugt ein Szenario vor, welches beeinträchtigte Fahreigenschaften verglichen mit einem Normalbetrieb hat, und insbesondere eine maximale Beladung und/oder eine niedrige Netzspannung, und/oder Gegenwind, umfasst. Da oft der Energieverbrauch unter Worst Case Bedingungen interessant ist, können diese die Fahrt beeinträchtigenden Einflüsse in die Basisdaten einfließen und entsprechend die Bremsdaten beeinflussen.

Gemäß einem bevorzugten Verfahren ist die Prüflok-Komponente eine Prüflok und die Bremslok-Komponente eine Bremslok, bzw. wird als Prüflok-Komponente eine Prüflok und als Bremslok-Komponente eine Bremslok verwendet. Insbesondere in diesem Fall umfasst das Steuersystem zwei Steuereinheiten. Dabei weist die Prüflok-Komponente (also bevorzugt die Prüflok) eine eigene Steuereinheit auf, an die die Fahrdaten übermittelt werden und welche dazu ausgelegt ist, die Testfahrt der Prüflok-Komponente gemäß den Fahrdaten zu steuern. Die Bremslok-Komponente (also bevorzugt die Bremslok) weist eine eigene Steuereinheit auf, an die die Bremsdaten übermittelt werden und welche dazu ausgelegt ist, die Bremslok-Komponente während der Testfahrt gemäß den Bremsdaten zu bremsen. Da die meisten Loks bzw. Triebeinheiten solche Steuereinheiten umfassen, ist ein solches Steuersystem sehr einfach zu realisieren. Es muss im Grunde einfach eine Datenkommunikation stattfinden, bei der die Bremsdaten der Steuereinheit der Bremslok-Komponente zugehen und die Fahrdaten der Steuereinheit der Prüflok-Komponente. Es wäre noch vorteilhaft, dass die Möglichkeit einer Synchronisation beider Steuereinheiten vorhanden ist. Eine einfache Lösung wäre, die Position auf der simulierten Strecke zu bestimmen.

Als Teststrecke kann im Grunde jede beliebige Strecke verwendet werden, insbesondere sofern ihre Eigenschaften bekannt sind, was jedoch insbesondere bei Vermessung von Wagenkonfigurationen nicht unbedingt der Fall sein muss. In einem Fall, in dem lediglich die Wagen von der Bremslok-Komponente simuliert werden sollen, kann theoretisch eine ganz normale Strecke als Teststrecke verwendet werden.

Gemäß einem bevorzugten Verfahren hat die Teststrecke jedoch eine geschlossene Streckenführung und ist bevorzugt ringförmig, insbesondere kreisförmig. Besonders bevorzugt umfasst sie Kurven und gerade Streckenabschnitte, insbesondere zwei Kreishälften, welche zusammen mit parallelen, geraden Streckenabschnitten einen Ring bilden.

Gemäß einem bevorzugten Verfahren sind bzw. werden die Bremsdaten so gestaltet, dass das Fahrprofil der Bremslok-Komponente während der Testfahrt so steuerbar ist, dass Fahrwiderstände einer vorgegebenen Strecke sowie einer vorgegebenen Zugkomposition abgebildet werden. Die Fahrdaten sind bzw. werden dabei bevorzugt so gestaltet, dass das Fahrprofil der Prüflok-Komponente während der Testfahrt dermaßen steuerbar ist, dass ein vorgegebenes Fahrprofil abgebildet wird. Das abgebildete Fahrprofil sollte einem Fahrprofil entsprechen, wie es ein Lokführer unter betrieblichen Bedingungen anwenden würde, also eine normale Fahrt.

Bevorzugt verläuft die Steuerung von Prüflok-Komponente und Bremslok-Komponente dermaßen synchron, dass bei einer simulierten Fahrt auf einer simulierten Strecke an vorgegebenen Streckenpositionen ein vorgegebenes Fahrprofil angewandt wird. Betrachtet man die simulierte Strecke, dann sollte sich also Prüflok-Komponente und Bremslok-Komponente zu gleichen Zeiten an derselben Position befinden, damit die Fahrdaten und die Bremsdaten synchron angewendet werden.

Gemäß einem bevorzugten Verfahren sind bzw. werden die Bremsdaten so gestaltet, dass sie an die Prüflok-Komponente angehängte nicht-angetriebene Schienenfahrzeuge, insbesondere Güterwagen und/oder Personenwagen simulieren, wobei insbesondere mittels numerischer Strömungsmechanik (häufig wird der englische Begriff Computational Fluid Dynamics, CFD verwendet) Fahrwiderstände der Fahrzeuge ermittelt werden. Es gehen also die Fahrwiderstände von Wagen in die Bremsdaten ein, welche vollständig simuliert sind. Die realen Wagen müssen dabei noch nicht existieren. Damit lassen sich also gezielt auch Einflüsse neuer Wagentypen simulieren.

Gemäß einem bevorzugten Verfahren umfasst die Teststrecke bevorzugt eine eigene, steuerbare Spannungsversorgung. Dies ermöglicht eine klar vorgegebene Variation der Spannung während der Testfahrt. Die Testfahrt erfolgt dann mit einer vorgegebenen Netzspannung, wobei die Netzspannung während der Testfahrt nach einem vorgegebenen Profil variiert wird.

Gemäß einem bevorzugten Verfahren werden Umweltbedingungen, insbesondere Wind und/oder Temperatur, während der Testfahrt gemessen. Der gemessene Energieverbrauch wird dann bevorzugt in Abhängigkeit von dieser Messung angepasst. Auf einer kreisförmigen Strecke ist das Problem mit Wind nicht gravierend, da auf einer Kreisfahrt der Wind von dem Loksystem aus gesehen von allen Seiten weht. Jedoch wird auf dem Kreis eine reale Fahrt auf einer realen Strecke abgebildet, so dass unterschiedliche Geschwindigkeiten innerhalb einer Umrundung gefahren werden könnten. Da der Windwiderstand geschwindigkeitsabhängig ist, diese Abhängigkeit jedoch bekannt oder zumindest ermittelbar ist, kann der Einfluss von Wind auf der Testfahrt herausgerechnet werden. Einflüsse durch die Temperatur, z.B. auch den Energieverbrauch der Kühlung, können ebenfalls herausgerechnet werden.

Gemäß einem bevorzugten Verfahren wird die Testfahrt mehrfach durchgeführt. Bevorzugt werden dabei bei unterschiedlichen Testfahrten die Fahrdaten und oder die Bremsdaten nach einem vorgegebenen Schema variiert. Dies hat den Vorteil, dass man künstlich eine "Verschmierung" der Testdaten erreicht, was eine größere Sicherheit für das Endergebnis darstellt. Für einen Kunden kann dann sicherheitshalber der jeweils höchste Energieverbrauch als Endergebnis angegeben werden. Es ist bevorzugt, dass die Variation der Bremsdaten Gegenverkehr und/oder Tunnelfahrten und/oder Wettereinflüsse, insbesondere Wind, simuliert. Bevorzugt simuliert die Variation der Fahrdaten Störungen im Betriebsablauf und/oder Abweichungen von Fahrprofilen durch Wettereinflüsse.

Gemäß einem bevorzugten Verfahren werden die Fahrdaten variiert, bevorzugt bei nicht-variierten Bremsdaten. Es wird dann der Energieverbrauch für mehrere Testfahrten gemessen und die Testfahrt mit dem günstigsten Energieverbrauch ermittelt wird. Die entsprechenden Fahrdaten für diese Testfahrt werden dann ausgegeben. Auf diese Art und Weise kann man eine Vorgabe für eine Fahrt einer Lok auf einer Strecke für einen Lokführer angeben. Beispielsweise kann für eine Lok mit einer Batterie ermittelt werden, welche Fahrweise auf einer Strecke den geringsten Energieverbrauch aufweist. Bevorzugt werden dabei in den Fahrdaten Beschleunigungsprofile und/oder Bremsprofile (also die Art der Bremsungen in den Fahrdaten) und/oder eine Steuerung einer Kühlung von Antriebskomponenten der Prüflok-Komponente variiert.

Somit kann die Erfindung neben dem reinen Nachweis des Energieverbrauchs auch für weitere Untersuchungen eingesetzt werden. Beispielsweise kann wie vorangehend erklärt auch das Kundenfahrspiel als Basis für spezifische Optimierungen eingesetzt werden. Das heißt, wenn geplant ist, ein Fahrzeug (die Prüflok-Komponente oder ein simulierter Wagen) auf einer bestimmten Strecke mit entsprechendem Fahrplan zu betreiben, kann das Fahrzeug oder die Fahrweise mit Hilfe des Emulators speziell für diesen Einsatzzweck optimiert werden und z.B. die Kühlung der Antriebskomponenten so energieeffizient wie möglich parametriert werden. Vor allem für den Personenverkehr (vorzugsweise mit Triebzügen) lässt sich damit die Energieeffizienz der Fahrzeuge nochmals steigern.

Gemäß einem bevorzugten Verfahren geht zumindest in die Bremsdaten das Profil der Teststrecke in einer Weise ein, dass Kurvenradien und insbesondere auch Steigungen und Gefälle der Teststrecke kompensiert werden. Auf diese Weise kann der Einfluss der Teststrecke auf die Messungen eliminiert werden, da die Eigenschaften der Teststrecke die Messung nicht beeinflussen sollten. Die Teststrecke beeinflusst mit ihren Steigungen, Kurven und eventuell vorhandenen Weichen das Testergebnis. Durch eine Steigung auf der Teststrecke müsste die Prüflok-Komponente zusätzlich Kraft aufwenden, um diese zu überwinden. Diese Einflüsse werden entsprechend in den Bremsdaten gegengerechnet, um die Einflüsse durch die Topografie der Teststrecke zu kompensieren.

Hierzu ist bevorzugt, dass eine Tabelle oder eine mathematische Funktion existiert, in welcher die zusätzlichen Teststreckeneinflüsse in Abhängigkeit von der GPS-Position aufgetragen sind. Bei Erreichen der entsprechenden Position fließen diese Einflüsse in die Bremsdaten mit ein. Statt einer Positionsermittlung per GPS kann auch die Kilometrierung der Teststrecke zur Positionsermittlung herangezogen werden. Da Teststrecken meist sehr eben sind und die Kurvenradien meist sehr groß sind, sodass deren Einfluss vergleichsweise gering ist kann auch ein speziell eingestellter (ggf. auch statischer) Regler auf der Bremslok-Komponente den Einfluss der Strecke zufriedenstellend gut kompensieren.

Gemäß einem bevorzugten Verfahren erfolgt zusätzlich eine Messung der Temperatur einer Anzahl von Komponenten der Prüflok-Komponente, insbesondere von Traktionskomponenten, während diese gemäß den Fahrdaten gesteuert wird und gleichzeitig durch die Bremslok-Komponente gemäß den Bremsdaten gebremst wird. Es wird also neben dem Energieverbrauch auch die Temperatur der Prüflok-Komponente überwacht.

Mit dem Stand der Technik lässt sich der Kundenwunsch nach einem detaillierten Nachweis des Energieverbrauchs nicht optimal erfüllen. Die Erfindung bietet einen "Fahrspiel-Emulator" für dynamische Messungen, um jede gewünschte Fahrspielvorgabe messtechnisch mit geringem Aufwand zu untersuchen. Der Aufwand für die Organisation einer Testfahrt (Bestellung Strecke und Fahrzeuge, Test, streckenkundiger Triebzugführer) ist durch die Erfindung stark reduziert.

Das erfindungsgemäße Konzept des Fahrspiel-Emulators erfüllt den wichtigsten Aspekt des messtechnischen Nachweises wie er am Markt gefordert wird. Durch den Emulator ist es möglich jede gewünschte Konstellation von Zug, Strecke und Fahrplan zu analysieren und so aufzubereiten, dass die Messfahrt mit zwei Lokomotiven auf beliebiger Strecke durchgeführt werden kann. Für die Messung ist im Grunde nur ein einziges Fahrzeug notwendig, z.B. ein Triebzug oder es sind nur noch zwei Fahrzeuge notwendig, die Prüflok und eine Bremslok. Da die Charakteristik der Teststrecke (Kurvenradien, Steigungen etc.) ebenfalls im Emulator durch Parametrierung simuliert werden kann, besteht die Möglichkeit, die Messung auf jeder verfügbaren Strecke durchzuführen. Die Fahrprofile können auf beide Fahrzeuge aufgespielt werden, und das voreingestellte Fahrspiel wird automatisch abgefahren, ein Eingreifen durch einen Triebzugführer ist daher nicht erforderlich. Hierdurch werden die Vorgaben für die Messfahrt sehr exakt eingehalten, was die Genauigkeit und Reproduzierbarkeit stark erhöht und mögliche Nachmessungen sehr unwahrscheinlich macht. Die Testzeit wird also maximal effektiv genutzt.

Auch in einer frühen Projekt-, Ausschreibungs- oder Akquise-Phase ohne physisch verfügbare Fahrzeuge (z.B. Wagen) kann durch die Testfahrt gezeigt werden, wie sich das anzubietende Fahrzeug verhalten wird und welche Energieverbräuche jeweils zu erwarten sind. Mit der Erfindung können damit Vorabtests mit dem späteren Fahrspiel realisiert werden, um anspruchsvolle Passagen im Fahrspiel frühzeitig vor dem realen Betrieb zu identifizieren und entsprechende Optimierungen bereits vor dem ersten Betriebstag einzubringen. Die Fahrzeugsteuerung, vor allem in Bezug auf das Kühlsystem, kann mittels des erfindungsgemäßen Emulators sehr individuell angepasst werden.

Weitere Möglichkeiten für den Einsatz bestehen bei verschiedenen Tests der Typprüfung oder Regressionstest. Hier können mit Hilfe der Automatisierung der zeitliche und personelle Aufwand reduziert werden.

Die Erfindung wird im Folgenden unter Hinweis auf die beigefügten Figuren anhand von Ausführungsbeispielen noch einmal näher erläutert. Dabei sind in den verschiedenen Figuren gleiche Komponenten mit identischen Bezugsziffern versehen. Die Figuren sind in der Regel nicht maßstäblich. Es zeigen:
Figur 1 eine Skizze eines Beispiels für ein erfindungsgemäßes System von oben,
Figur 2 ein Blockschaltbild eines Beispiels für ein erfindungsgemäßes Verfahren,
Figur 3 eine Skizze zur Generierung von Fahrdaten und Bremsdaten.

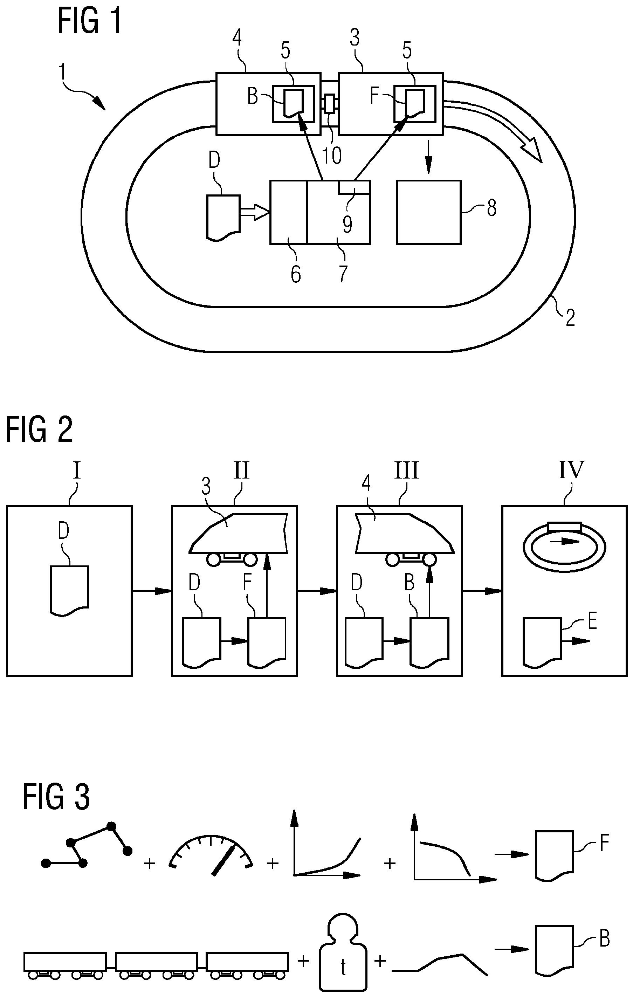

Figur 1 zeigt eine Skizze eines Beispiels für ein erfindungsgemäßes System 1 zur Ermittlung eines Energieverbrauchs einer Prüflok 3 bei einer Testfahrt von oben. Hier wird die Prüflok3 und deren Steuereinheit 5 auch als Teil des Systems 1 angesehen, was jedoch nicht unbedingt notwendig ist. Das System kann im Grunde für viele unterschiedliche Prüfloks 3 aber auch zur Vermessung von Wagen oder Triebwagen verwendet werden. Das System umfasst neben der Prüflok 3 (als Beispiel für eine Prüflok-Komponente) die folgenden Komponenten:
Eine Bremslok 4 (als Beispiel für eine Bremslok-Komponente) mit einer Kupplung 10, mit der sie für die Testfahrt mit der Prüflok 3 zu einem Loksystem 3, 4 gekuppelt ist. Auch wenn durchaus noch weitere Wagen angekuppelt sein können, ist die dargestellte Grundkonfiguration im Grunde ausreichend, es sei denn, der Einfluss eines realen Wagens auf die Testfahrt soll gemessen werden.

Ein Steuersystem 5, welches dazu ausgelegt ist, Bremslok 4 und Prüflok 3 zu steuern. Bevorzugt umfasst das Steuersystem 5 zumindest eine Steuereinheit 5 für die Bremslok 4, und eine Schnittstelle zur Datenübertragung an die Prüflok 3. Ist die Prüflok 3 Teil des Systems 1, kann das Steuersystem aus den Steuereinheiten 5 von Bremslok 4 und Prüflok 3 gebildet werden.

Eine Teststrecke 2, auf der das Loksystem 3, 4 während der Testfahrt fährt.

Eine Datenschnittstelle 6 ausgelegt zum Empfang von Basisdaten D zur Testfahrt umfassend zumindest Informationen zur Zugkomposition, Beladung, Streckenprofil und zum Fahrplan.

Eine Ermittlungseinheit 7, die zumindest für drei Funktionen ausgelegt ist, wobei diese Funktionen durchaus in verschiedenen Modulen getrennt bearbeitet werden können.

Die Ermittlungseinheit 7 dient zum einen zum Ermitteln von Fahrdaten F aus den Basisdaten D, welche zumindest Informationen zur Zugkraft und zu Geschwindigkeitsprofilen der Testfahrt umfassen, und dazu ausgelegt sind, die Prüflok 3 während der Testfahrt auf der Teststrecke 2 zu steuern.

Des Weiteren dient die Ermittlungseinheit 7 zum Ermitteln von Bremsdaten B, welche zumindest Informationen zur Hemmung bei der Testfahrt durch die Zugkomposition, Beladung und das Streckenprofil umfassen, und dazu ausgelegt sind, die Bremslok4 während der Testfahrt auf der Teststrecke 2 gemäß der Hemmung zu bremsen.

Letztlich dient die Ermittlungseinheit 7 noch Übermitteln der Fahrdaten F und Bremsdaten B an das Steuersystem 5, wobei die Bremsdaten B zum Bremsen der Bremslok 4 vorgesehen sind und die Fahrdaten F zum Steuern der Prüflok 3. Umfasst das Steuersystem 5 die Steuereinheiten 5 der beiden Loks, so können die Bremsdaten B an die Steuereinheit 5 der Bremslok 4 gesendet werden und die Fahrdaten F an die Steuereinheit 5 der Prüflok 3.

Eine Messeinheit 8 ausgelegt zur Messung des Energieverbrauchs der Prüflok 3 während diese auf einer Testfahrt mit dem Loksystem 3, 4 auf der Teststrecke 2 gemäß den Fahrdaten F gesteuert wird und gleichzeitig durch die Bremslok 4 gemäß den Bremsdaten B gebremst wird.

Figur 2 zeigt ein Blockschaltbild eines Beispiels für ein erfindungsgemäßes Verfahren zur Ermittlung eines Energieverbrauchs einer Lok bei einer Testfahrt, z.B. mit einem System nach Figur 1.

In Schritt I werden Basisdaten D zur Testfahrt bereitgestellt, die zumindest Informationen zur Zugkomposition, Beladung, Streckenprofil und zum Fahrplan umfassen.

In Schritt II werden Fahrdaten F aus den Basisdaten D ermittelt, welche zumindest Informationen zur Zugkraft und zu Geschwindigkeitsprofilen der Testfahrt umfassen, und dazu ausgelegt sind, die Prüflok 3 während der Testfahrt auf der Teststrecke 2 zu steuern. Diese Fahrdaten F werden dann an das Steuersystem 5 übermittelt, z.B. an die Steuereinheit 5 der Prüflok 3.

In Schritt III werden Bremsdaten B aus den Basisdaten D ermittelt, welche zumindest Informationen zur Hemmung bei der Testfahrt durch die Zugkomposition, Beladung und das Streckenprofil umfassen, und dazu ausgelegt sind, die Bremslok 4 während der Testfahrt auf der Teststrecke 2 gemäß der Hemmung zu bremsen. Diese Bremsdaten B werden dann an das Steuersystem 5 übermittelt, z.B. an die Steuereinheit 5 der Bremslok 4.

In Schritt IV wird eine Testfahrt mit dem Loksystem 3, 4 auf der Teststrecke 2 durchgeführt und der Energieverbrauch und ggf. weitere Größen wie z.B. die Temperatur gemessen. Der Energieverbrauch ist hier mittels der Energiedaten E symbolisiert. Während der Messung wird die Prüflok 3 gemäß den Fahrdaten F gesteuert und gleichzeitig durch die Bremslok 4 gemäß den Bremsdaten B gebremst.

Figur 3 zeigt eine Skizze zur Generierung von Fahrdaten F (oben) und Bremsdaten B (unten). Die Fahrdaten F werden von links nach rechts aus dem Fahrplan (insbesondere den Haltepunkten), der Fahrgeschwindigkeit des Zuges (insbesondere einem Geschwindigkeitsprofil), Beschleunigungskurven (wie beim Anfahren beschleunigt wird), Abbremskurven (wie vor einem halt abgebremst wird) gebildet.

Die Bremsdaten B werden von links nach rechts aus der Zugkomposition, der Beladung (hier durch ein Gewicht symbolisiert) und dem Profil der Strecke gebildet.

Es wird abschließend noch einmal darauf hingewiesen, dass es sich bei den vorhergehend detailliert beschriebenen Verfahren sowie bei dem dargestellten System lediglich um Ausführungsbeispiele handelt, welche vom Fachmann in verschiedenster Weise modifiziert werden können, ohne den Bereich der Erfindung zu verlassen. Weiterhin schließt die Verwendung der unbestimmten Artikel "ein" bzw. "eine" nicht aus, dass die betreffenden Merkmale auch mehrfach vorhanden sein können. Ebenso schließen die Begriffe "Einheit" und "Gerät" nicht aus, dass die betreffenden Komponenten aus mehreren zusammenwirkenden Teil-Komponenten bestehen, die gegebenenfalls auch räumlich verteilt sein können. Der Ausdruck "eine Anzahl" ist als "mindestens eins" zu verstehen.

## Patentansprüche

1. Verfahren zur Ermittlung eines Energieverbrauchs eines Schienenfahrzeugs bei einer Testfahrt umfassend die Schritte:
a) Bereitstellen eines Loksystems (3, 4) umfassend eine Bremslok-Komponente (4) und eine Prüflok-Komponente (3), welche miteinander gekuppelt sind, wobei die Bremslok-Komponente (4) während der Testfahrt von der Prüflok-Komponente (3) bewegt wird, und wobei ein Steuersystem (5) die Prüflok-Komponente (3) und die Bremslok-Komponente (4) während der Testfahrt steuert,
b) Bereitstellen einer Teststrecke (2), auf der das Loksystem (3, 4) während der Testfahrt fährt,
c) Bereitstellen von Basisdaten (D) zur Testfahrt umfassend zumindest Informationen zur Zugkomposition, Beladung, Streckenprofil und zum Fahrplan,
d) Ermitteln von Fahrdaten (F) aus den Basisdaten (D), welche zumindest Informationen zur Zugkraft und zu Geschwindigkeitsprofilen der Testfahrt umfassen, und dazu ausgelegt sind, die Prüflok-Komponente (3) während der Testfahrt auf der Teststrecke (2) zu steuern, und Übermitteln der Fahrdaten (F) an das Steuersystem (5),
e) Ermitteln von Bremsdaten (B) aus den Basisdaten (D), welche zumindest Informationen zur Hemmung bei der Testfahrt durch die Zugkomposition, Beladung und/oder das Streckenprofil umfassen, und dazu ausgelegt sind, die Bremslok-Komponente (4) während der Testfahrt auf der Teststrecke (2) gemäß der Hemmung zu bremsen, und Übermitteln der Bremsdaten (B) an das Steuersystem (5),
f) Durchführung der Testfahrt mit dem Loksystem (3, 4) auf der Teststrecke (2) und Messung des Energieverbrauchs der Prüflok-Komponente (3) während diese gemäß den Fahrdaten (F) gesteuert wird und gleichzeitig durch die Bremslok-Komponente (4) gemäß den Bremsdaten (B) gebremst wird.

2. Verfahren nach Anspruch **1,** wobei als Basisdaten (D) Fahrwiderstände der in der Zugkomposition eingesetzten Fahrzeuge verwendet werden, insbesondere wobei zumindest eine Größe der Gruppe Traktion, Gewicht und Luftwiderstand verwendet wird, und/oder wobei die Basisdaten (D) bevorzugt ein Szenario vorgeben, welches beeinträchtigte Fahreigenschaften verglichen mit einem Normalbetrieb hat, und insbesondere eine maximale Beladung und/oder eine niedrige Netzspannung, und/oder Gegenwind, vorgegeben werden.

3. Verfahren nach einem der vorangehenden Ansprüche, wobei als Prüflok-Komponente (3) eine Prüflok (3) verwendet wird und als Bremslok-Komponente (4) eine Bremslok (4) und wobei das Steuersystem (5) zwei Steuereinheiten (5) umfasst und
- die Prüflok-Komponente (3) eine eigene Steuereinheit (5) aufweist, an die die Fahrdaten (F) übermittelt werden und welche dazu ausgelegt ist, die Testfahrt der Prüflok-Komponente (3) gemäß den Fahrdaten (F) zu steuern und
- die Bremslok-Komponente (4) eine eigene Steuereinheit (5) aufweist, an die die Bremsdaten (B) übermittelt werden und welche dazu ausgelegt ist, die Bremslok-Komponente (4) während der Testfahrt gemäß den Bremsdaten (B) zu bremsen.

4. Verfahren nach einem der vorangehenden Ansprüche, wobei als Teststrecke (2) eine reale Strecke verwendet wird oder eine Teststrecke mit einer geschlossenen Streckenführung, die bevorzugt ringförmig, insbesondere kreisförmig, ist und besonders bevorzugt Kurven und gerade Streckenabschnitte umfasst.

5. Verfahren nach einem der vorangehenden Ansprüche, wobei die Bremsdaten (B) so gestaltet werden, dass das Fahrprofil der Bremslok-Komponente (4) während der Testfahrt so steuerbar ist, dass Fahrwiderstände einer vorgegebenen Strecke sowie einer vorgegebenen Zugkomposition abgebildet werden und die Fahrdaten (F) so gestaltet werden, dass das Fahrprofil der Prüflok-Komponente (3) während der Testfahrt so steuerbar ist, dass ein vorgegebenes Fahrprofil abgebildet wird,
bevorzugt wobei die Steuerung von Prüflok-Komponente (3) und Bremslok-Komponente (4) dermaßen simultan verläuft, dass bei einer simulierten Fahrt auf einer simulierten Strecke an vorgegebenen Streckenpositionen ein vorgegebenes Fahrprofil angewandt wird.

6. Verfahren nach einem der vorangehenden Ansprüche, wobei die Bremsdaten (B) so gestaltet werden, dass sie an die Prüflok-Komponente (3) angehängte nicht-angetriebene Fahrzeuge, insbesondere Güterwagen und/oder Personenwagen, simulieren, wobei insbesondere mittels numerischer Strömungsmechanik Fahrwiderstände der Fahrzeuge ermittelt werden.

7. Verfahren nach einem der vorangehenden Ansprüche, wobei die Teststrecke (2) eine eigene, steuerbare Spannungsversorgung aufweist und die Testfahrt mit einer vorgegebenen Netzspannung erfolgt, wobei die Netzspannung während der Testfahrt nach einem vorgegebenen Profil variiert wird.

8. Verfahren nach einem der vorangehenden Ansprüche, wobei Umweltbedingungen, insbesondere Wind und/oder Temperatur, während der Testfahrt gemessen werden und der gemessene Energieverbrauch in Abhängigkeit von dieser Messung angepasst wird.

9. Verfahren nach einem der vorangehenden Ansprüche, wobei die Testfahrt mehrfach durchgeführt wird und das bei unterschiedlichen Testfahrten die Fahrdaten (F) und/oder die Bremsdaten (B) nach einem vorgegebenen Schema variiert werden,
bevorzugt wobei die Variation der Bremsdaten (B) Gegenverkehr und/oder Tunnelfahrten und/oder Wettereinflüsse, insbesondere Wind, simuliert und/oder
bevorzugt wobei die Variation der Fahrdaten (F) Störungen im Betriebsablauf und/oder Abweichungen von Fahrprofilen durch Wettereinflüsse simuliert.

10. Verfahren nach Anspruch 9, wobei die Fahrdaten (F) variiert werden, bevorzugt bei nicht-variierten Bremsdaten (B), der Energieverbrauch für mehrere Testfahrten gemessen wird, die Testfahrt mit dem günstigsten Energieverbrauch ermittelt wird und die entsprechenden Fahrdaten (F) für diese Testfahrt ausgegeben werden,
bevorzugt wobei in den Fahrdaten (F) Beschleunigungsprofile und/oder Bremsprofile und/oder eine Steuerung einer Kühlung von Antriebskomponenten der Prüflok-Komponente (3) variiert werden.

11. Verfahren nach einem der vorangehenden Ansprüche, wobei zumindest in die Bremsdaten (B) das Profil der Teststrecke (2) in einer Weise eingeht, dass Kurvenradien und insbesondere auch Steigungen und Gefälle der Teststrecke (2) kompensiert werden.

12. Verfahren nach einem der vorangehenden Ansprüche, wobei zusätzlich eine Messung der Temperatur einer Anzahl von Komponenten der Prüflok-Komponente (3) erfolgt, insbesondere von Traktionskomponenten, während diese gemäß den Fahrdaten (F) gesteuert wird und gleichzeitig durch die Bremslok-Komponente (4) gemäß den Bremsdaten (B) gebremst wird.

13. System (1) zur Ermittlung eines Energieverbrauchs eines Schienenfahrzeugs, insbesondere einer Lokomotive, einem Triebwagen, einem Triebzug oder einem Wagen, bei einer Testfahrt unter Verwendung des Verfahrens gemäß einem der vorangehenden Ansprüche, das System (1) umfassend:
- in dem Fall, in dem als Schienenfahrzeug ein nichtangetriebenes Schienenfahrzeug vermessen werden soll, ein Loksystem (3, 4) umfassend eine Prüflok-Komponente (3), insbesondere eine Prüflok (3), und eine Bremslok-Komponente (4), insbesondere eine Bremslok (4), und in dem Fall, in dem als Schienenfahrzeug ein angetriebenes Schienenfahrzeug vermessen werden soll, eine Bremslok (4) als Bremslok-Komponente (4) mit einer Kupplung (10), mit der sie für eine Testfahrt mit dem angetriebenen Schienenfahrzeug als Prüflok-Komponente (3) zu einem Loksystem (3, 4) gekuppelt werden kann,
- ein Steuersystem (5) dazu ausgelegt, Bremslok-Komponente (4) und Prüflok-Komponente (3) zu steuern, bevorzugt umfassend zumindest eine Steuereinheit (5) für die Bremslok-Komponente (4), und eine Schnittstelle (9) zur Datenübertragung an die Prüflok-Komponente (3),
- eine Teststrecke (2), auf der das Loksystem (3, 4) während der Testfahrt fährt,
- eine Datenschnittstelle (6) ausgelegt zum Empfang von Basisdaten (D) zur Testfahrt umfassend zumindest Informationen zur Zugkomposition, Beladung, Streckenprofil und zum Fahrplan,
- eine Ermittlungseinheit (7) ausgelegt zum
i) Ermitteln von Fahrdaten (F) aus den Basisdaten (D), welche zumindest Informationen zur Zugkraft und zu Geschwindigkeitsprofilen der Testfahrt umfassen, und dazu ausgelegt sind, die Prüflok-Komponente (3) während der Testfahrt auf der Teststrecke (2) zu steuern,
ii) Ermitteln von Bremsdaten (B) aus den Basisdaten (D), welche zumindest Informationen zur Hemmung bei der Testfahrt durch die Zugkomposition, Beladung und/oder das Streckenprofil umfassen, und dazu ausgelegt sind, die Bremslok-Komponente (4) während der Testfahrt auf der Teststrecke (2) gemäß der Hemmung zu bremsen,
iii) Übermitteln der Fahrdaten (F) und Bremsdaten (B) an das Steuersystem (5), wobei die Bremsdaten (B) zum Bremsen der Bremslok-Komponente (4) vorgesehen sind und die Fahrdaten (F) zum Steuern der Prüflok-Komponente (3),
- eine Messeinheit (8) ausgelegt zur Messung des Energieverbrauchs der Prüflok-Komponente (3) während diese auf einer Testfahrt mit dem Loksystem (3, 4) auf der Teststrecke (2) gemäß den Fahrdaten (F) gesteuert wird und gleichzeitig durch die Bremslok-Komponente (4) gemäß den Bremsdaten (B) gebremst wird.

14. Computerprogrammprodukt, umfassend Befehle, die bei der Ausführung des Programms durch einen Computer diesen veranlassen, zumindest die Schritte c) bis f) des Verfahrens nach einem der Ansprüche 1 bis 12 auszuführen, wobei die Durchführung der Testfahrt entsprechend Schritt f) der Ausgabe von Steuerdaten zur Steuerung des Loksystems (3, 4) entspricht.

15. Computerlesbares Speichermedium, umfassend Befehle, die bei der Ausführung durch einen Computer diesen veranlassen, zumindest die Schritte c) bis f) des Verfahrens nach einem der Ansprüche 1 bis 12 auszuführen, wobei die Durchführung der Testfahrt entsprechend Schritt f) der Ausgabe von Steuerdaten zur Steuerung des Loksystems (3, 4) entspricht.

## Claims

1. Method for determining an energy consumption of a rail vehicle during a test run comprising the steps of:
a) providing a locomotive system (3, 4) comprising a brake locomotive component (4) and a test locomotive component (3) which are coupled together, wherein the brake locomotive component (4) is moved by the test locomotive component (3) during the test run, and wherein a control system (5) controls the test locomotive component (3) and the brake locomotive component (4) during the test run,
b) providing a test track (2) on which the locomotive system (3, 4) runs during the test run,
c) providing basic data (D) for the test run, including at least information on the train composition, loading, track profile and timetable,
d) determining running data (F) from the basic data (D), which comprise at least information on the tractive force and speed profiles of the test run and are designed to control the test locomotive component (3) during the test run on the test track (2), and transmitting the running data (F) to the control system (5),
e) determining braking data (B) from the basic data (D), which comprise at least information on the inhibition during the test run by the train composition, loading and/or the track profile and are designed to brake the brake locomotive component (4) during the test run on the test track (2) in accordance with the inhibition, and transmitting the braking data (B) to the control system (5),
f) carrying out the test run with the locomotive system (3, 4) on the test track (2) and measuring the energy consumption of the test locomotive component (3) while it is running according to the running data (F) and at the same time is braked by the brake locomotive component (4) in accordance with the braking data (B).

2. Method according to Claim 1, wherein running resistances of the vehicles used in the train composition are used as basic data (D), in particular wherein at least one variable from the group of traction, weight and air resistance is used, and/or wherein the basic data (D) preferably specify a scenario which has impaired running characteristics compared with normal operation, and in particular a maximum loading and/or a low grid voltage and/or headwind are specified.

3. Method according to one of the preceding claims, wherein a test locomotive (3) is used as the test locomotive component (3) and a brake locomotive (4) is used as the brake locomotive component (4), and wherein the control system (5) comprises two control units (5) and
- the test locomotive component (3) has its own control unit (5), to which the running data (F) are transmitted and which is designed to control the test run of the test locomotive component (3) in accordance with the running data (F), and
- the brake locomotive component (4) has its own control unit (5), to which the braking data (B) are transmitted and which is designed to brake the brake locomotive component (4) during the test run in accordance with the braking data (B).

4. Method according to one of the preceding claims, wherein a real track is used as the test track (2) or a test track with a closed track guide, which is preferably ring-shaped, in particular circular, and particularly preferably comprises curves and straight track sections.

5. Method according to one of the preceding claims, wherein the braking data (B) are such that the driving profile of the brake locomotive component (4) can be controlled during the test run in such a way that running resistances of a predetermined track and of a predetermined train composition are mapped, and the running data (F) are such that the driving profile of the test locomotive component (3) can be controlled during the test run in such a way that a predetermined driving profile is mapped, preferably wherein the control of the test locomotive component (3) and brake locomotive component (4) proceed simultaneously in such a way that a predetermined driving profile is applied at predetermined track positions during a simulated run on a simulated track.

6. Method according to one of the preceding claims, wherein the braking data (B) are such that they simulate non-powered vehicles attached to the test locomotive component (3), in particular freight wagons and/or passenger wagons, wherein running resistances of the vehicles are determined in particular by means of numerical fluid mechanics.

7. Method according to one of the preceding claims, wherein the test track (2) has its own controllable voltage supply and the test run is carried out with a predetermined grid voltage, wherein the grid voltage is varied according to a predetermined profile during the test run.

8. Method according to one of the preceding claims, wherein environmental conditions, in particular wind and/or temperature, are measured during the test run and the measured energy consumption is adjusted as a function of this measurement.

9. Method according to one of the preceding claims, wherein the test run is carried out several times and during different test runs the running data (F) and/or the braking data (B) are varied according to a predetermined scheme,
preferably wherein the variation of the braking data (B) simulates oncoming traffic and/or tunnel driving and/or weather events, in particular wind, and/or
preferably wherein the variation of the running data (F) simulates disturbances in the operating sequence and/or deviations from driving profiles due to weather events.

10. Method according to Claim 9, wherein the running data (F) are varied, preferably with non-varied braking data (B), the energy consumption is measured for several test runs, the test run with the most favourable energy consumption is determined and the corresponding running data (F) are output for this test run,
preferably wherein acceleration profiles and/or braking profiles and/or a control of a cooling of drive components of the test locomotive component (3) are varied in the running data (F).

11. Method according to one of the preceding claims, wherein the profile of the test track (2) is included at least in the braking data (B) in such a way that curve radii and, in particular, ascents and descents of the test track (2) are compensated for.

12. Method according to one of the preceding claims, wherein additionally the temperature of a number of components of the test locomotive component (3) is measured, in particular of traction components, while said component is being controlled according to the running data (F) and is simultaneously braked by the brake locomotive component (4) in accordance with the braking data (B).

13. System (1) for determining an energy consumption of a rail vehicle, in particular a locomotive, a railcar, a multiple unit train or a wagon, during a test run using the method according to one of the preceding claims, the system (1) comprising:
- in the case in which a non-powered rail vehicle is to be measured as the rail vehicle, a locomotive system (3, 4) comprising a test locomotive component (3), in particular a test locomotive (3), and a brake locomotive component (4), in particular a brake locomotive (4), and in the case in which a powered rail vehicle is to be measured as the rail vehicle, a brake locomotive (4) as the brake locomotive component (4) with a coupling (10), with which it can be coupled to a locomotive system (3, 4) for a test run with the powered rail vehicle as the test locomotive component (3),
- a control system (5) designed to control brake locomotive component (4) and test locomotive component (3), preferably comprising at least one control unit (5) for the brake locomotive component (4), and an interface (9) for data transmission to the test locomotive component (3),
- a test track (2) on which the locomotive system (3, 4) runs during the test run,
- a data interface (6) designed to receive basic data (D) for the test run comprising at least information on the train composition, loading, track profile and timetable,
- a determination unit (7) designed to
i) determine running data (F) from the basic data (D), which comprise at least information on the tractive force and speed profiles of the test run and are designed to control the test locomotive component (3) during the test run on the test track (2),
ii) determine braking data (B) from the basic data (D), which comprise at least information on the inhibition during the test run by the train composition, loading and/or the track profile, and are designed to brake the brake locomotive component (4) during the test run on the test track (2) in accordance with the inhibition,
iii) transmit the running data (F) and braking data (B) to the control system (5), wherein the braking data (B) are provided for braking the brake locomotive component (4) and the running data (F) are provided for controlling the test locomotive component (3),
- a measuring unit (8) designed to measure the energy consumption of the test locomotive component (3) while it is controlled on a test run with the locomotive system (3, 4) on the test track (2) in accordance with the running data (F) and is simultaneously braked by the brake locomotive component (4) in accordance with the braking data (B).

14. Computer program product comprising instructions which, when the program is executed by a computer, prompt the computer to execute at least steps c) to f) of the method according to one of Claims 1 to 12, wherein the execution of the test run corresponding to step f) corresponds to the output of control data for controlling the locomotive system (3, 4).

15. Computer-readable storage medium comprising instructions which, when executed by a computer, prompt the computer to execute at least steps c) to f) of the method according to one of Claims 1 to 12, wherein the execution of the test run corresponding to step f) corresponds to the output of control data for controlling the locomotive system (3, 4).

## Revendications

1. Procédé de détermination d'une consommation d'énergie d'un véhicule ferroviaire lors d'un trajet d'essai, comprenant les étapes consistant à :
a) fournir un système de locomotive (3, 4) comprenant un composant de locomotive de freinage (4) et un composant de locomotive de test (3) qui sont couplés l'un à l'autre, dans lequel le composant de locomotive de freinage (4) est déplacé par le composant de locomotive de test (3) pendant le trajet d'essai, et dans lequel un système de commande (5) commande le composant de locomotive de test (3) et le composant de locomotive de freinage (4) pendant le trajet d'essai,
b) fournir un itinéraire d'essai (2) sur lequel le système de locomotive (3, 4) se déplace pendant le trajet d'essai,
c) fournir des données de base (D) pour le trajet d'essai comprenant au moins des informations sur la composition du train, le chargement, le profil d'itinéraire et l'horaire de trajet,
d) déterminer des données de trajet (F) à partir des données de base (D) qui comprennent au moins des informations sur la force de traction et les profils de vitesse du trajet d'essai et sont conçues pour commander le composant de locomotive de test (3) pendant le trajet d'essai sur l'itinéraire d'essai (2), et transmettre les données de trajet (F) au système de commande (5),
e) déterminer des données de freinage (B) à partir des données de base (D) qui comprennent au moins des informations sur l'entrave pendant le trajet d'essai due à la composition du train, à la charge et/ou au profil d'itinéraire, et sont conçues pour freiner le composant de locomotive de freinage (4) pendant le trajet d'essai sur l'itinéraire d'essai (2) en raison de l'entrave, et transmettre les données de freinage (B) au système de commande (5),
f) mettre en œuvre le trajet d'essai avec le système de locomotive (3, 4) sur l'itinéraire d'essai (2) et mesurer la consommation d'énergie du composant de locomotive de test (3) pendant que celui-ci est commandé conformément aux données de trajet (F) et est en même temps freiné grâce au composant de locomotive de freinage (4) conformément aux données de freinage (B).

2. Procédé selon la revendication 1, dans lequel des résistances au roulement des véhicules utilisés dans la composition de train sont utilisées comme données de base (D), en particulier dans lequel au moins une grandeur issue du groupe comprenant traction, poids et résistance à l'air est utilisée, et/ou dans lequel les données de base (D) spécifient de manière préférée un scénario présentant des caractéristiques de conduite altérées par rapport à un fonctionnement normal, dans lequel une charge maximale et/ou une faible tension de réseau, et/ou un vent contraire sont en particulier spécifié(e)s.

3. Procédé selon l'une quelconque des revendications précédentes, dans lequel une locomotive de test (3) est utilisée comme composant de locomotive de test (3) et une locomotive de freinage (4) est utilisée comme composant de locomotive de freinage (4) et dans lequel le système de commande (5) comprend deux unités de commande (5) et
- le composant de locomotive de test (3) présente sa propre unité de commande (5) à laquelle sont transmises les données de trajet (F) et qui est conçue pour commander le trajet d'essai du composant de locomotive de test (3) conformément aux données de trajet (F) et
- le composant de locomotive de freinage (4) présente sa propre unité de commande (5) à laquelle sont transmises les données de freinage (B) et qui est conçue pour freiner le composant de locomotive de freinage (4) pendant le trajet d'essai conformément aux données de freinage (B).

4. Procédé selon l'une quelconque des revendications précédentes, dans lequel un itinéraire réel ou un itinéraire d'essai avec un tracé fermé, de manière préférée annulaire, en particulier circulaire, et comprenant de manière particulièrement préférée des courbes et des sections de piste droites, est utilisé comme itinéraire d'essai (2).

5. Procédé selon l'une quelconque des revendications précédentes, dans lequel les données de freinage (B) sont conçues de manière à ce que le profil de conduite du composant de locomotive de freinage (4) puisse être commandé pendant le trajet d'essai de sorte que les résistances au roulement d'un itinéraire prédéfini ainsi que la composition de train prédéfinie soient représentées et les données de trajet (F) sont conçues de sorte que le profil de conduite du composant de locomotive de test (3) puisse être commandé pendant le trajet d'essai de sorte qu'un profil de conduite prédéfini soit représenté,
dans lequel la commande du composant de locomotive de test (3) et du composant de locomotive de freinage (4) intervient de manière tellement simultanée qu'un profil de conduite prédéfini est appliqué lors d'une conduite simulée sur un itinéraire simulé au niveau de positions d'itinéraire prédéfinies.

6. Procédé selon l'une quelconque des revendications précédentes, dans lequel les données de freinage (B) sont conçues de manière à simuler des véhicules non entraînés, en particulier des wagons de marchandises et/ou des voitures de tourisme, qui sont attaché(e)s au composant de locomotive de test (3), dans lequel des résistances à la conduite des véhicules sont déterminées en particulier au moyen d'une mécanique de circulation numérique.

7. Procédé selon l'une quelconque des revendications précédentes, dans lequel l'itinéraire d'essai (2) présente sa propre alimentation en tension commandable et le trajet d'essai est effectué avec une tension de réseau prédéfinie, dans lequel la tension de réseau est modifiée selon un profil prédéfini pendant le trajet d'essai.

8. Procédé selon l'une quelconque des revendications précédentes, dans lequel les conditions environnementales, en particulier le vent et/ou la température, sont mesurées pendant le trajet d'essai et la consommation d'énergie mesurée est ajustée en fonction de ladite mesure.

9. Procédé selon l'une quelconque des revendications précédentes, dans lequel le trajet d'essai est effectué plusieurs fois et les données de trajet (F) et/ou les données de freinage (B) sont modifiées selon un schéma prédéfini lors de différents trajets d'essai,
dans lequel la variation des données de freinage (B) simule de manière préférée le trafic en sens inverse et/ou les trajets en tunnel et/ou les influences météorologiques, en particulier le vent, et/ou
dans lequel la variation des données de trajet (F) simule de manière préférée des perturbations du fonctionnement et/ou des écarts dans les profils de conduite en raison des influences météorologiques.

10. Procédé selon la revendication 9, dans lequel les données de trajet (F) sont modifiées, de manière préférée pour les données de freinage (B) non modifiées, la consommation d'énergie est mesurée pour plusieurs trajets d'essai, le trajet d'essai est déterminé avec la consommation d'énergie la plus avantageuse et les données de trajet (F) correspondantes sont émises pour ledit trajet d'essai,
dans lequel des profils d'accélération et/ou des profils de freinage et/ou une commande de refroidissement des composants d'entraînement du composant de locomotive de test (3) sont de manière préférée modifiés au sein des données de trajet (F).

11. Procédé selon l'une quelconque des revendications précédentes, dans lequel le profil de l'itinéraire d'essai (2) entre au moins dans les données de freinage (B) de manière à compenser les rayons de courbe et en particulier les montées et les descentes de l'itinéraire d'essai (2).

12. Procédé selon l'une quelconque des revendications précédentes, dans lequel une mesure de la température d'un certain nombre de composants du composant de locomotive de test (3), en particulier des composants de traction, intervient tandis que celui-ci est commandé conformément aux données de trajet (F) et est freiné en même temps par le composant de locomotive de freinage (4) conformément aux données de freinage (B).

13. Système (1) permettant de déterminer la consommation d'énergie d'un véhicule ferroviaire, en particulier d'une locomotive, d'un autorail, d'un train automoteur ou d'un wagon, lors d'un trajet d'essai en utilisant le procédé selon l'une quelconque des revendications précédentes, le système (1) comprenant :
- dans le cas où un véhicule ferroviaire non entraîné doit être mesuré en tant que véhicule ferroviaire, un système de locomotive (3, 4) comprenant un composant de locomotive de test (3), en particulier une locomotive de test (3), et un composant de locomotive de freinage (4), en particulier une locomotive de freinage (4), et dans le cas où un véhicule ferroviaire entraîné doit être mesuré en tant que véhicule ferroviaire, une locomotive de freinage (4) faisant office de composant de locomotive de freinage (4) avec un accouplement (10) avec lequel elle peut être accouplée pour un trajet d'essai avec le véhicule ferroviaire entraîné faisant office de composant de locomotive de test (3) afin de fournir un système de locomotive (3, 4),
- un système de commande (5) conçu pour commander le composant de locomotive de freinage (4) et le composant de locomotive de test (3), comprenant de manière préférée au moins une unité de commande (5) pour le composant de locomotive de freinage (4), et une interface (9) pour la transmission de données au composant de locomotive de test (3),
- un itinéraire d'essai (2) sur lequel le système de locomotive (3, 4) se déplace pendant le trajet d'essai,
- une interface de données (6) conçue pour recevoir des données de base (D) pour le trajet d'essai, comprenant au moins des informations sur la composition de train, le chargement, le profil d'itinéraire et l'horaire de trajet,
- une unité de détermination (7) conçue pour
i) déterminer des données de trajet (F) à partir des données de base (D) qui comprennent au moins des informations sur la force de traction et sur les profils de vitesse du trajet d'essai et sont conçues pour commander le composant de locomotive de test (3) pendant le trajet d'essai sur l'itinéraire d'essai (2),
ii) déterminer des données de freinage (B) à partir des données de base (D) qui comprennent au moins des informations sur l'entrave lors du trajet d'essai due à la composition de train, la charge et/ou le profil d'itinéraire, et sont conçues pour freiner le composant de locomotive de freinage (4) pendant le trajet d'essai sur l'itinéraire d'essai (2) conformément à l'entrave,
iii) transmettre les données de trajet (F) et les données de freinage (B) au système de commande (5), dans lequel les données de freinage (B) sont prévues pour freiner le composant de locomotive de freinage (4) et les données de trajet (F) sont prévues pour commander le composant de locomotive de test (3),
- une unité de mesure (8) conçue pour mesurer la consommation d'énergie du composant de locomotive de test (3) pendant qu'il est commandé lors d'un trajet d'essai avec le système de locomotive (3, 4) sur l'itinéraire d'essai (2) conformément aux données de trajet (F) et est simultanément freiné par le composant de la locomotive de test (4) conformément aux données de freinage (B).

14. Produit de programme informatique comprenant des instructions qui, lorsque le programme est exécuté par un ordinateur, amènent celui-ci à mettre en œuvre au moins les étapes c) à f) du procédé selon l'une quelconque des revendications 1 à 12, dans lequel la mise en œuvre du trajet d'essai correspond à l'étape f) d'émission de données de commande en vue de la commande du système de locomotive (3, 4).

15. Moyen de stockage pouvant être lu par un ordinateur, comprenant des instructions qui, lorsque le programme est exécuté par un ordinateur, amènent celui-ci à mettre en œuvre au moins les étapes c) à f) du procédé selon l'une quelconque des revendications 1 à 12, dans lequel la mise en œuvre du trajet d'essai correspond à l'étape f) d'émission de données de commande en vue de la commande du système de locomotive (3, 4).
